# EUROPEAN PATENT APPLICATION

(11) **EP 2 416 636 A2**
(43) Date of publication of application: **08.02.2012**
(21) Application number: 10192795.2
(22) Date of filing: 26.11.2010
(51) Int. Cl.: H05K 5/02

(54) **A portable storage device and a manufacturing method thereof**

(30) Priority: 02.08.2010 CN 201020278968 U
(71) Applicant: JMTek Technology (Shenzhen) Co., Ltd., Nanshan District Shenzhen Guangdong 518054 (CN)
(72) Inventor: Lee, Kyu Bong, Shenzen Guangdong 518054 (CN)
(74) Representative: Cheyne, John Robert Alexander M.

(57) **Abstract**

A portable storage device comprises an outer shell (20) and a chip carrier (10) carrying a memory chip (11), wherein the outer shell (20) is provided with a plastic body (21) holding the chip carrier (10) and a decorative layer consisting of a metal lid (22), a decorative sheet (23) and a transparent film (24). The decorative sheet (23) and the transparent film (24) in turn are crimped on the metal lid (22) fastened on the plastic body (21) by a mould. The present invention also provides a manufacturing method for portable storage devices that can be used to produce the aforementioned portable storage device. The portable storage device of the invention greatly improves the flexibility of the portable storage devices, enabling replacement of decorative patterns and provides more convenience for the users, while the stored functions thereof are achieved; and due to the provision of the metal lid (22), the impact resistance of the portable storage device is greatly improved.

## Description

### FIELD OF THE INVENTION

The invention relates to the field of data storage technology, in particular to a portable storage device and manufacturing method thereof.

### BACKGROUND OF THE INVENTION

Portable storage devices are convenient tools for storing and moving data in daily life or work. Known portable storage devices generally include chip shells of flash memory chip and fixed chip. In order to facilitate carrying, most portable storage devices also have accommodating chip shells and outer shells made of plastic material. In addition, some portable storage devices are also provided with detachable closed outer shells that cover the chip interface for preventing intrusion of water and dust.

With the increase of the frequency of utilization, more and more users prefer to hang the mobile storage devices on the retaining rings for facilitating carrying. In order to meet the users' needs, the surface of the outer shell of a number of movable storage devices is arranged with decorative patterns with all sorts of styles. However, because most of the existing decorative patterns are printed on the surface of the outer shell by the way of silk screen printing, patterns and styles are fixed and it's difficult for the users to replace the patterns.

### CONTENTS OF THE INVENTION

According to the present invention there is provided a portable storage device comprising an outer shell and a chip carrier carrying at least one memory chip, wherein the outer shell comprises a plastic body to which the chip carrier is connected, and a decorative layer comprising a metal lid, a decorative sheet and a transparent film, the decorative sheet and the transparent film being crimped on the metal lid, which is retained on the plastic body.

The present invention aims to achieve the flexibility of replacing decorative patterns of the surface layer of the outer shell and improve the flexibility of the decoration of the existing portable storage devices.

Preferably, the front side of the plastic body is provided with an accommodating groove confroming to the outline of the chip shell, the front end of which is pivoted with that of the chip shell, while the back side thereof is arranged with a convex edge by which the metal lid is secured.

Preferably , the side face of the back end of the accommodating groove is arranged with an embossment holding the chip shell, whose both sides are provided with depressions corresponding to the embossment, the back side of the chip shell being flush with the end face of the outer shell after it is clamped in the accommodating groove by the embossment and the depressions.

Preferably , the periphery of the plastic body is provided with a lug extending outwards, on which a punch-hole is arranged, in the direction corresponding to the accommodating groove.

Preferably, the back end of the accommodating groove is arranged with a recess for assiting engagement of the chip shell.

Preferably, the or each memory chip is glued to the chip shell by a double-faced adhesive tape.

Preferably, a hinge pin passes through the chip shell and is inserted into the front end of the accommodating groove so that the chip shell is pivoted with respect to the accommodating groove.

Preferably, the front end of the accommodating groove is provided with a cylindrical projection, the front end of the chip shell having a hole which is a clearance fit with the cylindrical projection so that the chip shell is pivoted with the outer shell by the cylindrical projection and the hole.

Preferably, the outline of the plastic body is round or polygonal.

Another aspect of the present invention provides a manufacturing method for portable storage devices comprising an outer shell and a chip carrier carrying at least one memory chip, characterized in that the method includes:
crimping a metal lid in turn by a mould with a transparent film and a decorative sheet so as to form a decorative layer;
fastening the metal lid in the outer shell so as to be fixed on the plastic body of the outer shell.

Preferably, the method further includes:
gluing the memory chips and the chip shell by a double-faced adhesive tape;
pivoting the front ends of the chip shell and the accommodating groove which is arranged on the front side of the plastic body and whose outline is adapted to the chip shell.

Preferably, the transparent film and the decorative sheet in turn are crimped on the metal lid by the mould so as to form the decorative layer, by:
placing the metal lid whose surface is in turn covered by the decorative sheet and the transparent film in the die cavity of a lower die;
pressing an upper die downwards so that the transparent film and the decorative sheet cling to the outer surface of the metal lid, and pushing the die core of the lower die against the inner part of the metal lid so that the decorative sheet and the transparent film cling to the inner surface of the metal lid.

Preferably, the metal lid is fastened in the outer shell so as to be fixed on the plastic body of the chip shell, by:
placing the plastic body with its back side up in the die cavity of another lower die and the decorative layer correspondingly;
pressing the upper die downwards so that the edges of the metal lid undergo flexural deformations and are fastened with a convex edge of the back side of the plastic body.

Preferably, the front end of the chip shell is pivoted with that of the accommodating groove which is arranged on the front side of the plastic body and whose outline is adapted to the chip shell, by:
passing a hinge pin through the chip shell and inserting it into the front end of the accommodating groove so that the chip shell is pivoted with the accommodating groove.

Preferably, the front end of the chip shell is pivoted with that of the accommodating groove which is arranged on the front side of the plastic body and whose outline is adapted to the chip shell, by:
engaging a cylindrical projection that is arranged on the front end of the accommodating groove and a hole that is arranged on the front end of the chip shell and has a clearance fit with the cylindrical projection.

The mobile storage device or the manufacturing method of the invention can be used to obtain a decorative layer consisting of a transparent film, a decorative sheet and a metal lid, which means when the users want to replace the decorative patterns, the metal lid is detached from the plastic body to replace the decorative sheet, and then the metal layer is fastened on the plastic body. The invention greatly improves the flexibility of the portable storage devices replacing decorative patterns and provides more convenience for the users, while the stored functions thereof are achieved. Owing to the provision of the metal lid, the impact resistance of the portable storage device is greatly improved.

### BRIEF DESCRIPTION OF THE DRAWINGS

For a better understanding of the present invention and to show more clearly how it may be carried into effect, reference will now be made, by way of example, to the accompanying drawings, in which:
Fig.1 is a structural schematic view of a portable storage device in one implementation of the invention;
Fig.2 is a structural schematic view of an outer shell in one embodiment of the invention;
Fig.3 is a structural schematic view of the stamping equipment in one embodiment of the invention;
Fig.4 is a schematic view of the positive structure of the outer shell in one embodiment of the invention;
Fig.5 is a schematic view of the pin-jointed structure of the chip shell and the plastic body in one embodiment of the invention;
Fig.6 is a schematic view of the pin-jointed structure of the chip shell and the plastic body in another embodiment of the invention;
Fig.7 is a flow chart of a manufacturing method for portable storage devices in one implementation of the invention;
Fig.8 is a process flow chart of obtaining the decorative layer in one embodiment of the invention;
Fig.9 is a process flow chart of obtaining the outer shell in one embodiment of the invention;

### DETAILED DESCRIPTION OF THE EMBODIMENTS

It should be understood that the embodiments described here are only used to explain the invention rather than limiting the present invention.

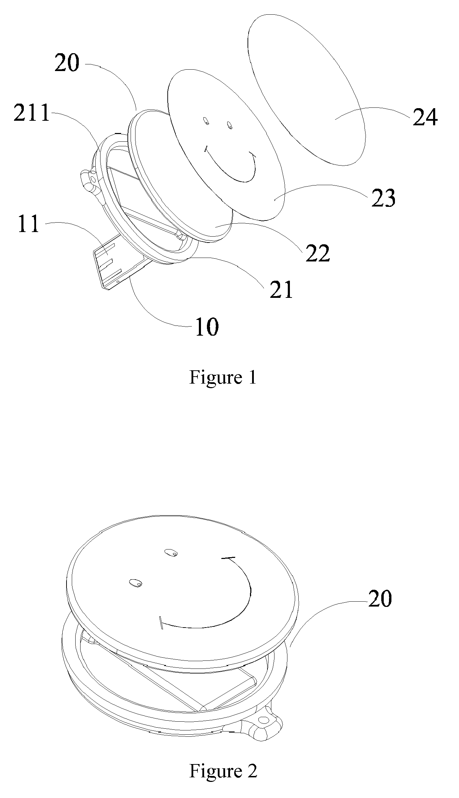

Referring to figs. 1 and 2, which are the structural schematic view of a portable storage device in one implementation of the invention, the portable storage device comprises a chip shell or carrier 10 and an outer shell 20.Memory chips 11 are secured to the chip carrier 10. The outer shell 20 comprises a plastic body 21 to which the chip carrier 10 is connected, and a decorative layer consisting of a metal lid 22, a decorative sheet, for example paper, 23 and a transparent film 24. The decorative sheet 23 and the transparent film 24 in turn are crimped by means of a mould onto the metal lid 22 fastened on the plastic body 21.

In one embodiment, the plastic body 21 comprises a convex edge 211 or raised rim that bulges outward to be fastened with the metal lid 22.

The patterns or colours on the decorative sheet 23 can be freely set so as to meet the uses' needs. To change the pattern, the metal lid 22 is detached from the plastic body 21 to enable replacement of the original decorative sheet 23 with a new one, and then the transparent film 24 and the decorative sheet 23 are crimped on the metal lid 22 by the mould, which is convenient and simple.

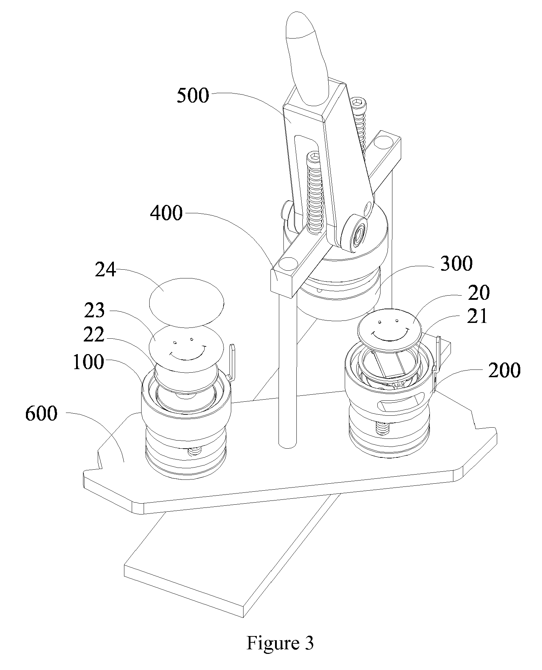

The overall dimensions of the decorative sheet 23 and the transparent film 24 are larger than those of the metal lid 22 so that they can wrap over the edges of the metal lid 22. The decorative layer can be formed by stamping equipment with a simple structure (see figure 3).

In one embodiment, the stamping equipment comprises a first lower die 100, a second lower die 200, an upper die 300, a die-set 400, a handle 500 and a lower die plate 600. The lower die plate 600 can rotate so that the first lower die 100 and the second lower die 200 are moved to the position corresponding to the upper die 300. In one embodiment, the overall dimensions of the decorative sheet 23 and the transparent film 24 are basically the same as each other and larger than those of the metal lid 22, so that they can wrap over the edges of the metal lid 22. The dimension of the die cavity of the first lower die 100 is slightly larger than the overall dimensions of the decorative sheet 23 and the transparent film 24. In one embodiment, the die core of the upper die 300 is provided with an inclined plane which presses the decorative sheet 23 and the transparent film 24 against the metal lid 22 when the upper die 300 presses downward. The base of the first lower die 100 is arranged with a spring, which causes the die sleeve of the first lower die 100 to float when the upper die 300 is contact with the first lower die 100, while the die core has relative movement so as to push against the inner cavity of the metal lid 22, thereby wrapping the inner surface of the metal lid 22 with the decorative sheet 23 and the transparent film 24 and obtaining the decorative layer.

After the decorative layer 20 is formed by the above method, the plastic body 21, with its back side up, is placed in the die cavity of the second lower die 200 and the decorative layer 20 is placed on the back side of the plastic body 21, then the lower die plate 600 is rotated so that the position of the second lower die 200 is corresponding with the upper die 300 and the handle 500 is pressed downwards so that the metal lid 22 wrapped with the decorative sheet 23 and the transparent film 24 undergoes inward deformations and is fastened on the convex edge 211 of the plastic body 21, thereby forming the outer shell 20.

The metal lid 22 can be made of steel, aluminium alloy etc. The transparent film 23 is arranged outside of the decorative sheet 24 to completely wrap the surface of the metal lid 22. Such structure plays the role of preventing intrusion of water and dust and the users can randomly replace the colors or patterns so as to meet the different needs of users.

It is well known that the impact resistance of metal is comparatively higher than that of plastics materials. Therefore, due to the assembly of the metal lid 22 in the portable storage device of the invention, when it is subjected to external impacts, the metal lid 22 can better protect internal portable storage chips from being damaged so as to improve the impact resistance of the portable storage device and prolong the service life thereof.

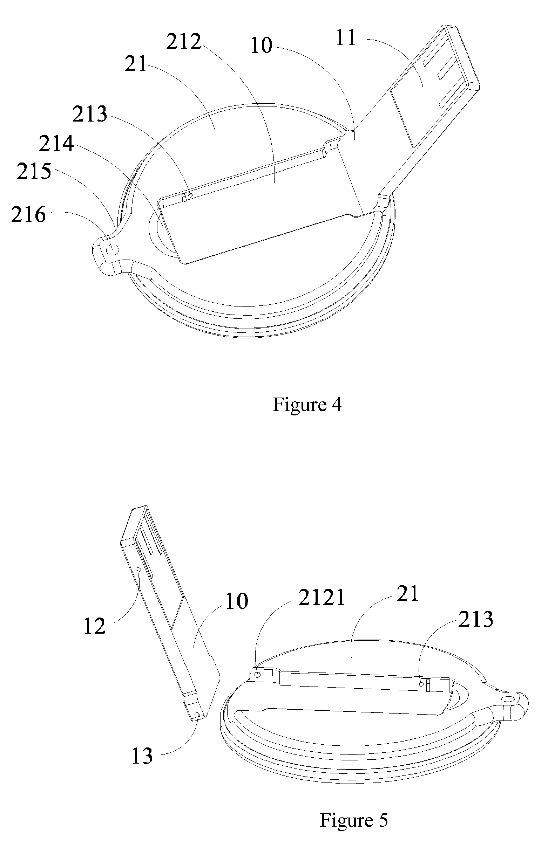

The memory chips 11 are fixed to the chip carrier 10, for example, by means of a double-faced adhesive tape. Other fixing techniques may be used. In the embodiment, the memory chips 11 can be connected with the chip carrier 10 by gluing, in a very convenient manufacturing process. Referring to fig. 4, in one embodiment the front side of the plastic body 21 is provided with an accommodating groove 212 conforming to the outline of the chip carrier 10. For example, the length, width and depth of the accommodating groove 212 are basically the same as those of the chip carrier 10 so that the chip carrier 10 can be completely accommodated in the accommodating groove 212. The front end of the chip carrier 10 is pivotably connected to the body 21 at the front end of the accommodating groove 212 , while the side face of the back end of the accommodating groove 212 is arranged with an embossment 213 for retaining the chip carrier 10 within the accommodating groove 212.

The embossment 213 can have the structure of bar-type or circular point type or a combination of bar-type and circular point type to retain the chip carrier 10. In one embodiment, both sides of the chip carrier 10 are provided with depressions 12 corresponding to the embossment 213; the back side of the chip carrier 10 is flush with the end face of the outer shell 20 after it is clamped in the accommodating groove 212 by the embossment 213 and the depressions 12.

By the assembly of the depressions 12 in the embodiment, the users can perceive whether the holding of the chip carrier 10 is in place, thereby improving the users' experience.

The chip carrier 10 is held in the accommodating groove 212 of the outer shell 20 when the portable storage device of the implementation is not in use , and the chip carrier 10 is pivoted away from the plastic body 24 when the portable storage device is in use. When not in use, the portable storage device of the implementation forms an integrated shape which can be carried as an ornament, thereby greatly improving the decoration of the portable storage device.

The periphery of the above plastic body 21 is provided with a lug 215 extending outwards, provided with a punch-hole 216, extending in the direction corresponding to the depth of the accommodating groove 212. The punch-hole 216 can receive a cord or buckle, so the portable storage device of the invention can be carried by the users. For example, the punch-hole 216 can receive a cord, through which the portable storage device of the invention can be carried by the users as an ornament; alternatively, the punch-hole 216 can receive a key ring so that the portable storage device of the invention can be carried as a key ring ornament.

Furthermore, the back end of the accommodating groove 212 in the outer shell 20 may comprise a recess 214 that can be used to draw the chip carrier 10 from the groove by the user's finger. For example, when the chip carrier 10 is held in the accommodating groove 212, the back end thereof is contact with that of the accommodating groove 212; however, if the gap between the chip carrier and the plastic body 21 is small because of the overall design, it can be inconvenient for the chip carrier 10 to be reversed about its pivot. By providing the recess 214 at the back end of the accommodating groove 212, the user's fingers can reach the accommodating groove 212 to reverse the chip carrier 10.

There is a variety of pin-jointed structures which can be used to connect the chip carrier 10 to the outer shell 20. With reference to fig 5, which is a schematic view of the pin-jointed structure of the chip carrier 10 and the plastic body 21 in one embodiment of the invention, the front end of the accommodating groove 212 is provided with a cylindrical projection 2121, and the front end of the chip carrier 10 is provided with a hole 13 which receives the projection 2121 as a clearance fit so that the chip carrier 10 is pivoted with the outer shell 20.

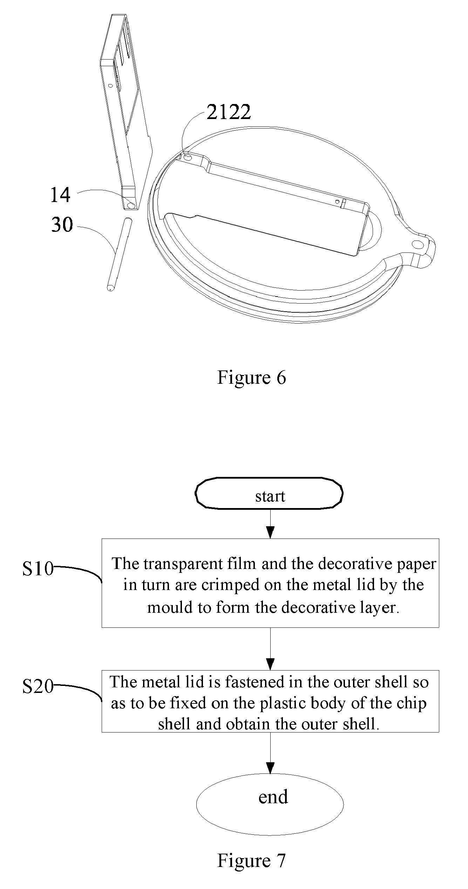

In another embodiment, the chip carrier 10 is pivotably connected to the plastic body 21 by means of a hinge pin 30. As shown in Fig. 6, the hinge pin 30 passes through a lateral passage 14 arranged on the front end of the chip carrier 10. Connecting holes 2122 are provided at the front end of the accommodating groove 212. The hinge pin 30 passes through the lateral passage 14 and is retained within the connecting holes 2122 so that the chip carrier 10 is pivoted with the outer shell 20.

The outline of the above plastic body 21 can be selected according to the needs of the users. For example, it can be circular as shown in the drawings, polygonal, elliptical or may have an irregular shape.

The invention further provides a manufacturing method for the above portable storage device, as shown in fig. 7, which includes the steps of:
Step S10: the transparent film and the decorative sheet in turn are crimped on the metal lid by the mould to form the decorative layer;
Step S20: the metal lid is fastened in the outer shell so as to be fixed on the plastic body of the chip carrier. The structure of the portable storage device can be in accordance with the embodiments shown in figs. 1 and 2. The outer shell 10 can be formed by the stamping equipment with a simple structure, in accordance with fig. 3 and the embodiments shown therein and will not be discussed here.

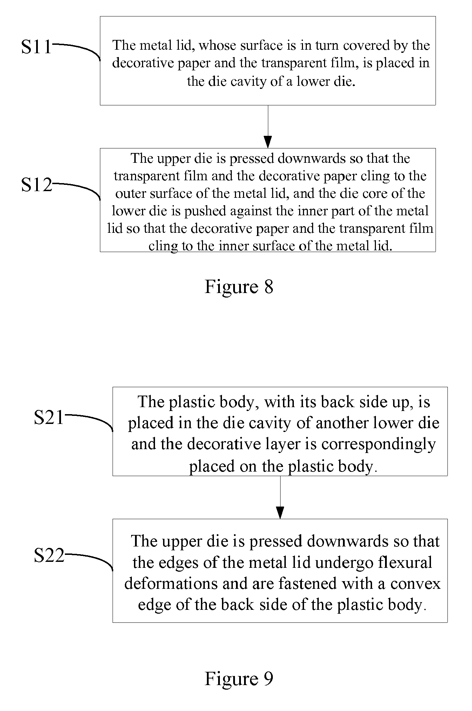

With reference to fig. 8, in one embodiment, the above step S10 can specifically include:
Step S11: the metal lid, whose surface is in turn covered by the decorative sheet and the transparent film, is placed in the die cavity of a lower die; the overall dimensions of the decorative sheet 23 and the transparent film 24 are basically the same as each other and larger than those of the metal lid 22, so that the edges of the metal lid 22 can be covered. The dimension of the die cavity of the first lower die 100 is slightly larger than the overall dimensions of the decorative sheet 23 and the transparent film 24.
Step S12: the upper die is pressed downwards so that the transparent film and the decorative sheet cling to the outer surface of the metal lid, and the die core of the lower die is pushed against the inner part of the metal lid so that the decorative sheet and the transparent film cling to the inner surface of the metal lid. In one embodiment, the die core of the upper die 300 is provided with an inclined plane which presses the decorative sheet 23 and the transparent film 24 against the metal lid 22 when the upper die 300 presses downward. The base of the first lower die 100 is arranged with a spring, which causes the die sleeve of the first lower die 100 to float when the upper die 300 is contact with the first lower die 100, while the die core has relative movement so as to push against the inner cavity of the metal lid 22, thereby wrapping the inner surface of the metal lid 22 with the decorative sheet 23 and the transparent film 24 and obtaining the decorative layer.

With reference to fig. 9, in one embodiment, the above step S20 can specifically include:
Step S21: the plastic body, with its back side up, is placed in the die cavity of another lower die and the decorative layer is correspondingly placed on the plastic body; in one embodiment, the another lower die is the above second lower die 200 whose die core can position the plastic body 21; since the dimension of the die cavity is slightly smaller than that of the metal lid 22, the second lower die 200 is arranged with a beveled edge so that the edges of the metal lid 22 can be bent.
Step S22: the upper die is pressed downwards so that the edges of the metal lid undergo flexural deformations and are fastened with a convex edge of the back side of the plastic body.

When the upper die 300 is pressed downwards, the die cavity of the second lower die 200 moves downwards and the edges of the metal lid 22 cover the convex edge 211; however, if the upper die 300 continues to be pressed downwards, the beveled edge of the second lower die 200 will cause the edges of the metal lid 22 to undergo inward flexural deformations so that the metal lid 22 is fastened with the convex edge 211, thereby obtaining the outer shell 20.

In one embodiment, the above method also includes the steps of gluing the memory chips to the chip carrier by a double-faced adhesive tape and pivotably connecting together the front ends of the chip carrier and the accommodating groove which is arranged on the front side of the plastic body and whose outline conforms to that of the chip carrier. The plastic body 21 can have a variety of shapes and structures. With reference to fig. 4, in one embodiment of the invention, the plastic body 21 is provided with an accommodating groove 212 to accommodate the chip carrier. There are many connection methods between the memory chips 11 and the chip carrier 10, which are fixed by a glued joint in the described embodiment, which has the advantages of convenience, simplicity and low cost. After making the glued joint, the chip carrier 10 is pivotably connected to the accommodating groove 212, thereby basically accomplishing the manufacturing process of the storage device of the invention.

In one embodiment, the above step S21 can include: passing the hinge pin through the chip carrier and inserting it into the front end of the accommodating groove so that the chip carrier is pivoted with the accommodating groove; or butting a cylindrical projection that is arranged on the front end of the accommodating groove into a hole that is arranged on the front end of the chip carrier and has a clearance fit with the projection.

## Claims

1. A portable storage device comprising an outer shell (20) and a chip carrier (10)carrying at least one memory chip(11), wherein the outer shell (20) comprises a plastic body (21) to which the chip carrier (10) is connected, and a decorative layer comprising a metal lid (22), a decorative sheet (23) and a transparent film (24), the decorative sheet (23) and the transparent film (24) being crimped on the metal lid (22), which is retained on the plastic body (21).

2. A portable storage device according to claim 1, **characterized in that** a front side of the plastic body (21) is provided with an accommodating groove (212) conforming to the outline of the chip carrier (10), a front end of the chip carrier (10) being pivotally connected to the plastic body (21) at a front end of the accommodating groove (212), the back side of the plastic body (21) being provided with a convex edge (211) to which the metal lid (22) is secured.

3. A portable storage device according to claim 2, **characterized in that** the plastic body (21) is provided at the rear end of the accommodating groove with an embossment (213), and the chip carrier (10)is provided on opposite sides with a depression (12) corresponding to the embossment for retaining the chip carrier (10) in the accommodating groove (212), a rear face of the chip carrier (10) being flush with the end face of the outer shell when the chip carrier (10) is retained in the accommodating groove (212) by the embossment (213) and the depression (12).

4. A portable storage device according to claim 3, **characterized in that** the periphery of the plastic body (21) is provided with a lug (215) extending outwards, a punch-hole (216) extending in the lug (215) in a direction corresponding to the depth of the accommodating groove (212).

5. A portable storage device according to any one of claims 2 to 4, **characterized in that** the back end of the accommodating groove (212) is provided with a recess (214) enabling engagement with the chip carrier (10).

6. A portable storage device according to claim 5, **characterized in that** the or each memory chip (11) is glued to the chip carrier (10) by a double-faced adhesive tape.

7. A portable storage device according to claim 2, **characterized in that** a hinge pin (30) passes through the chip carrier (10) and is inserted into the plastic body (21) at the front end of the accommodating groove (212) so that the chip carrier (10) is pivotable with respect to the accommodating groove (212).

8. A portable storage device according to claim 2, **characterized in that** the front end of the accommodating groove (212) is provided with a cylindrical projection (2121), and the front end of the chip carrier (10) is provided with a hole (13) which has a clearance fit with the cylindrical projection (2121) so that the chip carrier (10) is pivotably connected to the outer shell by the cylindrical projection (2121) and the hole (13).

9. A portable storage device according to claim 8, **characterized in that** the outline of the plastic body (21) is round or polygonal.

10. A manufacturing method for portable storage devices comprising an outer shell (20) and a chip carrier (10) carrying at least one memory chip (11), **characterized in that** the method includes:
crimping a metal lid (22) in turn by a mould with a transparent film (23) and a decorative sheet (24) so as to form a decorative layer;
fastening the metal lid (22) in the outer shell (20) so as to be fixed on the plastic body (21) of the outer shell (20).

11. A method according to claim 10, **characterized in that** the method further includes:
gluing the or each memory chip (11) to the chip carrier (10) by a double-faced adhesive tape;
pivotably interconnecting the front end of the chip carrier (10) to the plastic body (21) at a front end of an accommodating groove (212), which is arranged on the front side of the plastic body (21) and whose outline conforms with that of the chip carrier (10).

12. A method according to claim 10 or 11, **characterized in that** the transparent film (24) and the decorative sheet (23) in turn are crimped on the metal lid (22) by the mould so as to form the decorative layer, comprising:
placing the metal lid (22) whose surface is in turn covered by the decorative sheet (23) and the transparent film (24) in the die cavity of a lower die (100);
pressing an upper die (300) downwards so that the transparent film (24) and the decorative sheet (23) cling to the outer surface of the metal lid (22), and pushing a die core of the lower die (100) against the inner part of the metal lid (22) so that the decorative sheet (23) and the transparent film (24) cling to the inner surface of the metal lid (22).

13. A method according to claim 12, **characterized in that** the metal lid (22) is fastened in the outer shell (20) so as to be fixed on the plastic body (21) of the outer shell (20) by:
placing the plastic body (21) with its back side up in the die cavity of another lower die (200) and the decorative layer (23) correspondingly;
pressing the upper die (300) downwards so that the edges of the metal lid (22) undergo flexural deformations and are fastened with a convex edge (211) of the back side of the plastic body (21).

14. A method according to claim 13, **characterized in that** the front end of the chip carrier (10) is pivoted with respect to the accommodating groove (212) which is arranged on the front side of the plastic body (21) and whose outline is adapted to the chip carrier (10), by:
passing a hinge pin (30) through the chip carrier (10) and inserting it into the plastic body (21) at the front end of the accommodating groove (212) so that the chip carrier (10) is pivotable with respect to the accommodating groove (212).

15. A method according to claim 13, **characterized in that** the front end of the chip carrier (10) is pivoted with respect to the accommodating groove (212) which is arranged on the front side of the plastic body (21) and whose outline is adapted to the chip carrier (10), by:
engaging a cylindrical projection (2121) that is arranged on the plastic body (21) at the front end of the accommodating groove (212) with a hole (13) that is arranged on the front end of the chip carrier (10) and has a clearance fit with the cylindrical projection (2121)
